(19) Europäisches Patentamt
European Patent Office
Office européen des brevets

(11) **EP 2 479 897 A2**

(12) **EUROPEAN PATENT APPLICATION**

(43) Date of publication:
**25.07.2012 Bulletin 2012/30**

(51) Int Cl.:
***H03M 13/11*** *(2006.01)*

(21) Application number: **12000331.4**

(22) Date of filing: **19.01.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME** | (72) Inventor: **Hayami, Atsushi**<br>**Yokohama-shi**<br>**Kanagawa 221-0022 (JP)** |
| (30) Priority: **19.01.2011 JP 2011009070** | (74) Representative: **Schmidbauer, Andreas Konrad**<br>**Wagner & Geyer**<br>**Patent- und Rechtsanwälte**<br>**Gewürzmühlstrasse 5**<br>**80538 München (DE)** |
| (71) Applicant: **JVC Kenwood Corporation**<br>**Yokohama-shi, Kanagawa 221-0022 (JP)** | |

(54) **Decoding device and decoding method**

(57) A min-sum processing unit (46) executes, on input data, check node processing for each row of a check matrix and variable node processing for each column of the checkmatrix. When the decoded result involves an error, a detection unit (50) detects a bit of a low degree of reliability from the decoded result. An identifying unit (52) identifies a row and a column of a low degree of reliability in the check matrix on the basis of the bit of the low degree of reliability detected. The min-sum processing unit (46) executes, on the decoded result, check node processing on the row identified as well as variable node processing on the column identified.

FIG.10

**Description**

BACKGROUND OF THE INVENTION

1. Field of the Invention

The present invention relates to a decoding technique, and more particularly to a decoding device and a decoding method for decoding data encoded by LDPC.

2. Description of the Related Art

In recent years, LDPC (Low Density Parity Check Code) attracts attention as an error correction code having high error correction performance even in a transmission path with a low S/N, and the LDPC is applied in many fields. In the LDPC, data is encoded with an encoding matrix generated based on a sparse check matrix at a transmission side. In this case, the sparse check matrix is a matrix in which elements are either 1 or 0 and the number of 1s is small. On the other hand, data is decoded and parity check is performed based on the check matrix at a receiving side. In particular, the decoding performance is improved by iterative decoding according to BP (Belief Propagation) method and the like.

In this decoding, check node processing for decoding in a row direction of the check matrix and variable node processing for decoding in a column direction are repeatedly executed. Sum-product decoding using Gallager and hyperbolic functions is known as a check node processing. In the sum-product decoding, a communication path value obtained from a distribution value of transmission path noise is used as a priori value. A simplified decoding method of the sum-product decoding is min-sum decoding. In the min-sum decoding, check node processing can be performed by performing simple processings such as comparison operation and summation operation, without using complicated functions. Further, since the min-sum decoding does not require the communication path value, the min-sum decoding is widely used for simplifying and increasing the speed of processings. In the min-sum decoding, a determination is made as to whether the decoded bit is 1 or 0 based on a posterior probability obtained from iterative decoding. Thereafter, when a result of the parity check with the check matrix is zero, or the number of repetitions of decoding reaches a specific number, the repeat of decoding is terminated, and the decoding is terminated. Further, an attempt is made to reduce the number of times of operations using a degree of reliability of posterior probability (for example, see Japanese Patent Application Laid-Open No. 2008-219528).

Patent Document 1: Japanese Patent Application Laid-Open No. 2008-219528

In the min-sum decoding, the amount of operation is reduced as compared with the sum-product decoding. In recent years, the operation speed is greatly improved due to the advancements in parallel computing and arithmetic element processing. Therefore, not only the reduction of the amount of operation but also the increase of the speed of repeat processing are desired in the decoding of LDPC. In order to increase the speed of the repeat processing, for example, the number of repeat processings is reduced, and the repeat processing is simplified.

SUMMARY OF THE INVENTION

The present invention is made in view of such circumstances, and it is an obj ect of the present invention to provide a technique for improving the speed of the iterative decoding in the decoding of LDPC.

In order to solve the above problem, a decoding device according to an aspect of the present invention includes an input unit configured to input data subjected to LDPC encoding, a decoding unit configured to execute, on the data input by the input unit, check node processing for each row of a check matrix and variable node processing for each column of the check matrix, a detection unit configured to detect a bit of a low degree of reliability from a decoded result of the decoding unit when the decoded result of the decoding unit involves an error, and an identifying unit configured to identify a row and a column of a low degree of reliability from the check matrix on the basis of the bit of the low degree of reliability detected by the detection unit. The decoding unit executes, on the decoded result, check node processing of a row identified by the identifying unit and variable node processing of a column identified by the identifying unit.

According to this aspect, the row and the column subjected to the decoding processing can be limited by executing the check node processing on the row identified as well as executing the variable node processing on the column identified.

The detection unit may include a deriving unit configured to derive a magnitude of a posterior probability for each of a plurality of bits included in the decoded result of the decoding unit, and a comparison unit configured to compare the magnitude of the posterior probability derived by the deriving unit with a threshold value, thereby detecting a bit of which magnitude of the posterior probability is less than the threshold value, as a bit of a low degree of reliability. In this case, since a bit of a low degree of reliability is derived based on the magnitude of the posterior probability, the accuracy in detecting the bit of the degree of reliability can be improved.

When the decoded result obtained from repeated execution involves an error, the detection unit, the identifying unit, and the decoding unit may repeatedly execute the processing, and the comparison unit may change a threshold value according to the number of times of repeated executions. In this case, since the threshold value is changed according to the number of times of repeated executions, processing can be executed according to the number of times of repeated executions.

The decoding unit executes min-sum algorithm for the check node processing, and a normalization constant for execution of the check node processing of each row of the check matrix may be less than a normalization constant for execution of the check node processing of the row identified by the identifying unit. In this case, the normalization constant after the error detection is reduced, and accordingly the amount of update may be reduced.

Another aspect of the present invention is a decoding method. This method includes the steps of inputting data subjected to LDPC encoding, executing, on the input data, check node processing for each row of a checkmatrix, executing, on the input data, variable node processing for each column of the check matrix, detecting a bit of a low degree of reliability from a decoded result when the decoded result involves an error, identifying a row and a column of a low degree of reliability from the check matrix on the basis of the bit of the low degree of reliability detected, executing, on the decoded result, check node processing of a row identified, and executing, on the decoded result, variable node processing of a column identified.

The above constituent elements may be combined in any combination, and an expression of the present invention may be converted among a method, an apparatus, a system, a recording medium, a computer program, and the like. Such thing may also be effective as an aspect of the present invention.

BRIEF DESCRIPTION OF THE DRAWINGS

FIG. 1 is a figure illustrating a configuration of a communication system according to an embodiment of the present invention;

FIG. 2 is a figure illustrating a check matrix used in an LDPC encoding unit of FIG. 1;
FIG. 3 is a figure illustrating a configuration of a decoding unit of FIG. 1;
FIG. 4 is a figure illustrating a Tanner graph schematically illustrating operation of a decoding unit of FIG. 3;
FIG. 5 is a figure illustrating an overview of update of an external value ratio in the decoding unit of FIG. 3;
FIG. 6 is a figure illustrating an overview of update of a priori value ratio in the decoding unit of FIG. 3;
FIG. 7 is a figure illustrating a data structure of a table stored in a table storage unit of FIG. 3;
FIG. 8 is a figure illustrating a data structure of another table stored in the table storage unit of FIG. 3;
FIG. 9 is a figure illustrating overview of the contents of processings of an identifying unit of FIG. 3; and
FIG. 10 is a flowchart illustrating decoding procedure performed by the decoding unit of FIG. 3.

DETAILED DESCRIPTION OF THE INVENTION

The invention will now be described by reference to the preferred embodiments. This does not intend to limit the scope of the present invention, but to exemplify the invention.

First, overview will be stated before specifically describing the present invention. An embodiment of the present invention includes a communication system including a transmission apparatus for executing LDPC encoding and a reception apparatus executing iterative decoding, based on a check matrix, on data encoded by the transmission apparatus (hereinafter referred to as "encoded data"). In particular, the reception apparatus executes the min-sum algorithm. As described above, in the min-sum algorithm, the check node processing, and the variable node processing are repeatedly executed. This kind of min-sum algorithm can be achieved with simple processing, but in order to enhance the speed of the repeat processing, the communication system according to the present, and in particular the reception apparatus, are configured as follows.

In the min-sum algorithm, the check node processing and the variable node processing are repeatedly executed, so that the accuracy of decoding is enhanced. In this case, for example, the check node processing in the row direction is executed for one bit, and thereafter the variable node processing in the column direction is executed successively by shuffle decoding. The reception apparatus repeatedly executes the check node processing and the variable node processing for a specific number of times. At this occasion, when convergence cannot be made, i.e., a decoded result involves an error, the reception apparatus detects a bit of which degree of reliability is low, and identifies a row and a column including the detected bit. The reception apparatus executes the check node processing and the variable node processing only on the identified row and column. As described above, the speed of the repeat processing is enhanced by limiting the row and column to be processed.

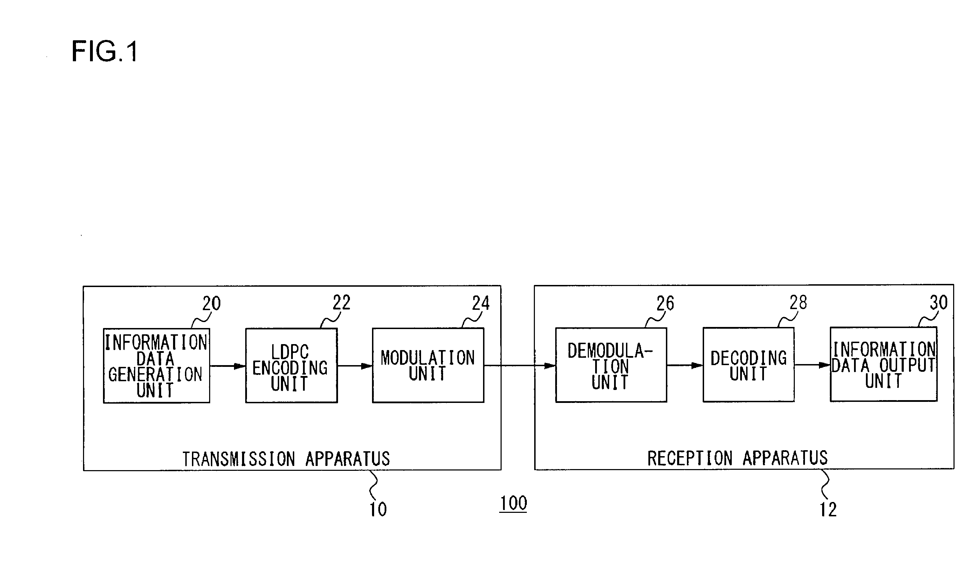

FIG. 1 illustrates a configuration of a communication system 100 according to the embodiment of the present invention. The communication system 100 includes a transmission apparatus 10 and a reception apparatus 12. The transmission apparatus 10 includes an information data generation unit 20, an LDPC encoding unit 22, and a modulation unit 24. The reception apparatus 12 includes a demodulation unit 26, a decoding unit 28, and an information data output unit 30.

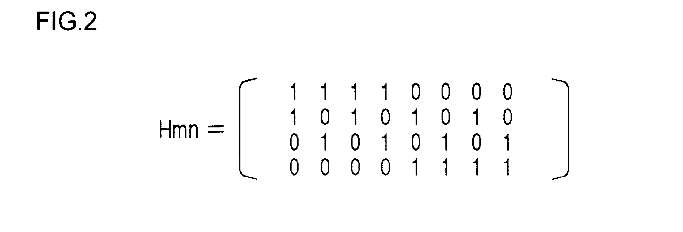

The information data generation unit 20 obtains data to be transmitted, and generates information data. Alternatively, the obtained data may be used as information data as it is. The information data generation unit 20 outputs the information data to the LDPC encoding unit 22. The LDPC encoding unit 22 receives the information data from the information data generation unit 20. The LDPC encoding unit 22 attaches a parity based on the check matrix of the LDPC (hereinafter referred to as "LDPC parity") to the information data. The information data attached with the LDPC parity corresponds to the encoded data. The LDPC encoding unit 22 outputs the encoded data to the modulation unit 24. FIG. 2 illustrates a check matrix used in the LDPC encoding unit 22. A check matrix Hmn is a matrix having m rows and n columns. In this case, for the sake of simplifying the description, the check matrix Hmn includes 4 rows and 8 columns, and the elements of the check matrix are either 1 or 0. However, the check matrix Hmn is not limited thereto. Reference is made to FIG. 1 again.

The modulation unit 24 receives the encoded data from the LDPC encoding unit 22. The modulation unit 24 modulates the encoded data. PSK (Phase Shift Keying), FSK (Frequency Shift Keying), and the like are used as modulation methods. The modulation unit 24 transmits modulated encoded data as a modulated signal. The demodulation unit 26 receives the modulated signal from the modulation unit 24 via a communication path such as a radio transmission path. The demodulation unit 26 demodulates the modulated signal. A known technique may be used for the demodulation, and therefore, description thereof will not be repeated. The demodulation unit 26 outputs a demodulation result (hereinafter referred to as "demodulated data") to the decoding unit 28.

The decoding unit 28 receives the demodulated data from the demodulation unit 26. The decoding unit 28 repeatedly executes the decoding processing on the demodulated data with the check matrix by the LDPC. For example, min-sum algorithm is executed as decoding processing. The min-sum algorithm is executed according to the following procedure.

  1. Initialization: the priori value ratio is initialized, and a maximum number of repetitions of decoding is set.
  2. Check node processing: the external value ratio is updated in the row direction of the check matrix.
  3. Variable node processing: the priori value ratio is updated in the column direction of the check matrix.
  4. A temporary estimated word is calculated.

Detailed description about this procedure will not be given. However, in the check node processing described below, a normalization constant is used. The decoding unit 28 outputs a decoded result (hereinafter referred to as "decoded data") to the information data output unit 30. The information data output unit 30 receives the decoded data from the decoding unit 28. The information data output unit 30 generates information data based on the decoded data. Alternatively, the decoded data may be used as the information data as they are. The information data output unit 30 includes an outer code decoding unit, and may decode, for example, an outer code of CRC (Cyclic Redundancy Check).

This configuration may be implemented by an LSI, memory, or a CPU of a computer in a hardware manner. This configuration may also be implemented by a program loaded to the memory in a software manner. In this case, functional blocks are implemented by a combination of the hardware and software manners. Therefore, it is understood by those skilled in the art that the functional blocks may be implemented by only hardware, only software, or a combination thereof.

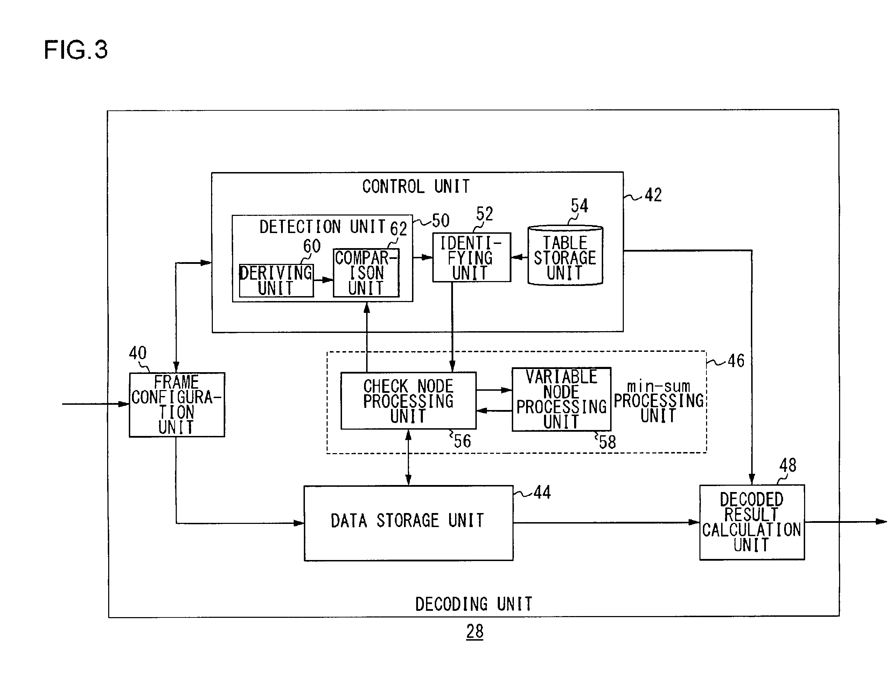

FIG. 3 illustrates a configuration of the decoding unit 28. The decoding unit 28 includes a frame configuration unit 40, a control unit 42, a data storage unit 44, a min-sum processing unit 46, and a decoded result calculation unit 48. Further, the control unit 42 includes a detection unit 50, an identifying unit 52, and a table storage unit 54. The detection unit 50 includes a deriving unit 60 and a comparison unit 62. The min-sum processing unit 46 includes a check node processing unit 56 and a variable node processing unit 58.

The frame configuration unit 40 receives the demodulated data from the demodulation unit 26, not shown. The demodulated data can be said to be data LDPC-encoded and transmitted via the communication path. The frame configuration unit 40 detects a frame synchronization signal included in the demodulated data. The frame configuration unit 40 identifies the unit of the frame formed by the demodulated data on the basis of the frame synchronization signal. For example, when a frame synchronization signal is arranged at the head portion of the frame, and the period of the frame is a fixed length, the frame configuration unit 40 detects the frame synchronization signal, and then identifies the period of the fixed length as the frame. It should be noted that the unit of the LDPC encoding may be a frame. The frame configuration unit 40 causes the data storage unit 44 to store demodulated data put together in units of frames. The data storage unit 44 temporarily stores the demodulation signal in units of frames.

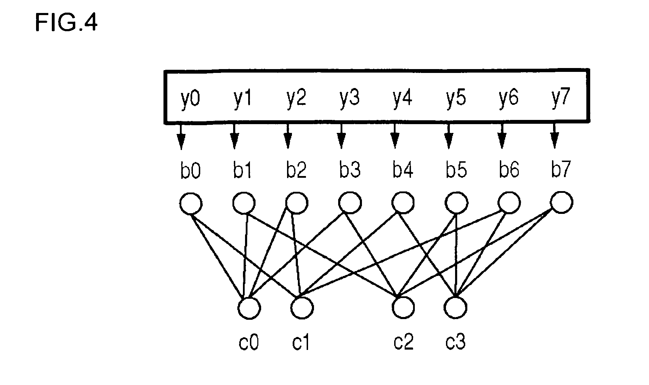

The min-sum processing unit 46 receives the demodulated data from the data storage unit 44. The min-sum processing unit 46 executes the min-sum algorithm on the demodulated data using the normalization constant. In the min-sum algorithm, the check node processing unit 56 and the variable node processing unit 58 are alternately executed. For example, in the min-sum processing unit 46, shuffle decoding is performed. After the check node processing in the row direction is executed for one bit, the variable node processing in the column direction is executed. FIG. 4 illustrates a Tanner graph schematically illustrating operation of the decoding unit 28. In the Tanner graph, b0 to b7 are called variable nodes, and c0 to c3 are called check nodes. In this case, the number of variable nodes is denoted as n, and bn represents the n-th variable node. The number of check nodes is denoted as m, and cm represents the m-th check node. The variable nodes b0 to b7 are connected to data y0 to y7 stored in the data storage unit 44 of FIG. 3. Reference is made to FIG. 3 again.

At first, in the iterative decoding, the check node processing unit 56 initializes the priori value ratio "β". In this case, the demodulated data stored in the data storage unit 44 is used as it is. Subsequently, the check node processing unit 56 obtains the minimum value of the absolute value of the priori value ratio "min|βmn'|". The check node processing unit 56 updates the external value ratio $\alpha mn$ from cm to bm, with the variable node connected to the check node. The calculation of $\alpha mn$ is performed as follows for all the combinations (m, n) satisfying the expression: check matrix Hmn=1.

$$\alpha mn = a(\Pi sign(\beta mn')) \cdot min|\beta mn'| \ \ldots \ (1)$$

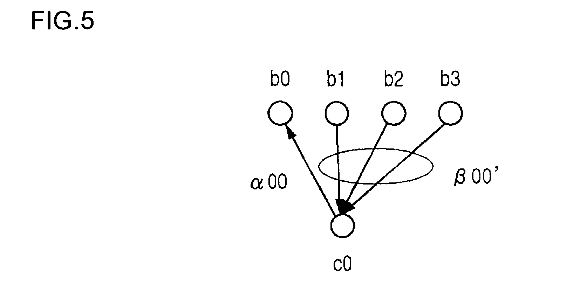

In this case, "n' "is "A (m) \n": "A (m) " is a set of variable nodes connected to the check node m; and "\n" denotes a difference set not including n. On other hand, "sign" denotes a signature function, and "min|βmn'|" denotes a selection of the minimum value of the absolute value. In this case, "a" is a normalization constant, which is stored in the check node processing unit 56 in advance. FIG. 5 illustrates an overview of update of an external value ratio in the decoding unit 28. The external value ratio $\alpha 00$ can be derived from $\beta 00'$. This can be said that, in order to update the external value $\alpha 00$ of b0, external values of b1, b2, b3 are used. In other words, the check node processing unit 56 updates the external value ratio based on the priori value ratio with regard to each row of the check matrix. Reference is made to FIG. 3 again. The minimum value of the absolute value of the priori value ratio, "min |βmn'|", is derived in each repeating.

The variable node processing unit 58 updates the priori value ratio βmn from bn to cm, with the check node connected to the variable node from $\alpha mn$. The calculation of βmn is performed as follows for all the combinations (m, n) satisfying the expression: check matrix Hmn=1.

$$\beta mn = \Sigma \alpha m'n + \lambda n \ \ldots \ (2)$$

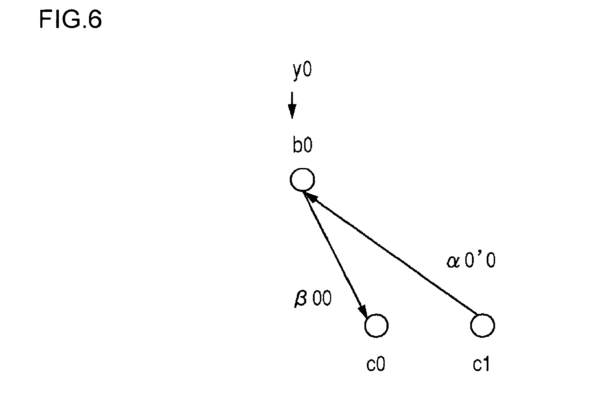

In this case, $\lambda n$ is equal to input data yn. The input data yn corresponds to the demodulated data provided by the demodulation unit 26. On the other hand, " m'" is "B(n)\m": "B(n) " is a set of check nodes connected to the variable node n; and "\m" denotes a difference set not including m. FIG. 6 illustrates an overview of update of the priori value ratio in the decoding unit 28. The priori value ratio β00 is derived from $\alpha 0'0$. In other words, the variable node processing unit 58 updates the priori value ratio on the basis of the external value ratio in each column of the check matrix. Reference is made to FIG. 3 again.

The decoded result calculation unit 48 calculates the temporary estimated word after the processing of the check node processing unit 56 and the processing of the variable node processing unit 58 are repeated a specific number of times. It should be noted that even before the processings are repeated the specific number of times, the decoded result calculation unit 48 may calculate the temporary estimated word as long as the result of the parity check is correct. In this case, the decoded result calculation unit 48 derives the temporary estimated word using the posterior probability as follows.

[Numerical expression 1]

The decoded result calculation unit 48 executes the parity check, and when the check result is correct, the decoded result calculation unit 48 outputs the temporary estimated word as the decoded result.

However, in some cases, even when the decoding processing is performed the specific number of times of repeating defined in advance while, e.g., the S/N of the transmission path is low, the decoding cannot be performed normally, and an error may be detected in the parity check. At that occasion, one more repeat processing is executed. In the present embodiment, even when the repeat processing is executed, the following processing is executed in order to improve the speed of the repeat processing. Even when the repeat processings for the specific number of times are finished, the deriving unit 60 derives the magnitude of the posterior probability for each of a plurality of bits included in the decoded result when the decoded result provided by the decoded result calculation unit 48 involves an error. More specifically, the deriving unit 60 receives a posterior probability pn for each bit from the decoded result calculation unit 48, and derives the square value of the posterior probability pn or the absolute value of the posterior probability pn as the magnitude of the posterior probability. The deriving unit 60 outputs the magnitude of the posterior probability pn with respect to each bit to the comparison unit 62.

The comparison unit 62 receives the magnitude of the posterior probability from the deriving unit 60. Further, the comparison unit 62 sets a threshold value in advance. The comparison unit 62 compares the magnitude of the posterior probability and the threshold value, and detects a bit of which the magnitude of the posterior probability is less than the threshold value as a bit having a low degree of reliability. As described above, the comparison unit 62 detects a bit having a low degree of reliability within the frame from the posterior probability obtained as a result of the variable node processing. In other words, the comparison unit 62 detects a bit of which degree of reliability is low from among the decoded result. The comparison unit 62 outputs a bit of a low degree of reliability to the identifying unit 52.

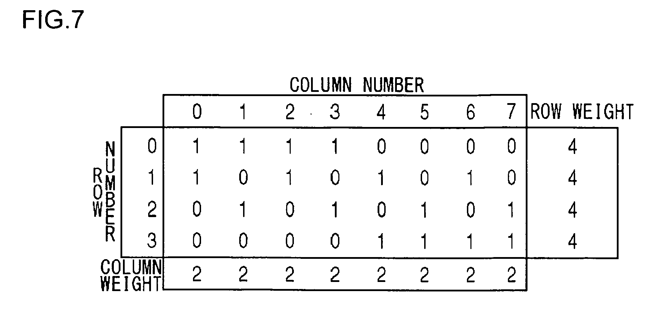

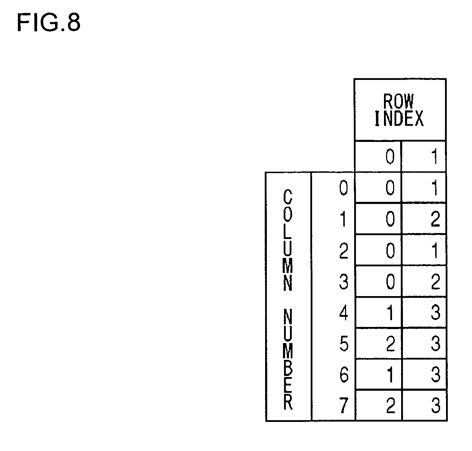

The table storage unit 54 stores a table for identifying a row and a column including a bit of a low degree of reliability in the check matrix. FIG. 7 illustrates a data structure of a table stored in the table storage unit 54. As shown in the figure, row numbers of the check matrix, column numbers of the check matrix, the number of 1s in each row direction, and the number of 1s in each column direction are stored. It should be noted that the number of 1s in each row direction is a row weight, and the number of 1s in each column direction is a column weight. FIG. 8 illustrates a data structure of another table stored in the table storage unit 54. As shown in the figure, a row index of a number corresponding to a column weight in FIG. 7 (the first row having 1 in each column direction is denoted as row index 0, and the second row is denoted as row index 1), and row numbers that can be output from the respective column numbers are stored. For example, when the degree of reliability of the bit b4 is low, the column weight is 2 as can be seen from FIG. 7, and two rows, i.e., the first row and the third row, can be derived from FIG. 8. Reference is made to FIG. 3 again.

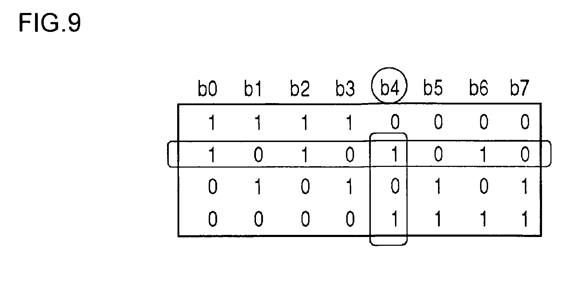

The identifying unit 52 receives the bit of the low degree of reliability from the comparison unit 62. The identifying unit 52 looks up the table stored in the table storage unit 54, and identifies a row and a column of a low degree of reliability in the check matrix on the basis of the bit of the low degree of reliability. FIG. 9 illustrates overview of the contents of processings of the identifying unit 52. In this case, it is assumed that the fifth bit calculated with the variable node b4 is the bit of the low degree of reliability. That is, $|p4|$ is less than a threshold value, for example, 1.0. In this case, information indicating that the bit of the low degree of reliability is in the fourth column and information indicating that the first row and the third row involve 1 may be conveyed to the min-sum processing unit 46, and therefore, the identifying unit 52 outputs the first row serving as a row of row index 0 and the third row serving as a row of index 1 on the basis of the table illustrated in FIG. 8. Further, the identifying unit 52 outputs the fourth column including b4. Reference is made to FIG. 3 again. The identifying unit 52 outputs the identified row and column to the min-sum processing unit 46.

The check node processing unit 56 executes the check node processing of the first row, and the variable node processing unit 58 executes the variable node processing of the fourth column. The row subjected to the check node and the column subjected to the variable node processing are enclosed by solid lines in FIG. 9. Subsequently, the check node processing unit 56 executes the check node processing of the third row, and the variable node processing unit 58 executes the variable node processing of the fourth column. With this operation, the iterative decoding performed on the bit of the low degree of reliability is finished once. That is, with regard to the decoded result, the min-sum processing unit 46 executes the check node processing on the row identified by the identifying unit 52 as well as executes the variable node processing on the column identified by the identifying unit 52. The decoded result calculation unit 48 executes the temporary estimated word using the posterior probability again. The decoded result calculation unit 48 executes the parity check again, and when decoding is done normally, the decoding is terminated. On the other hand, the decoded result calculation unit 48 repeatedly executes the decoding operation when the decoding is not done normally.

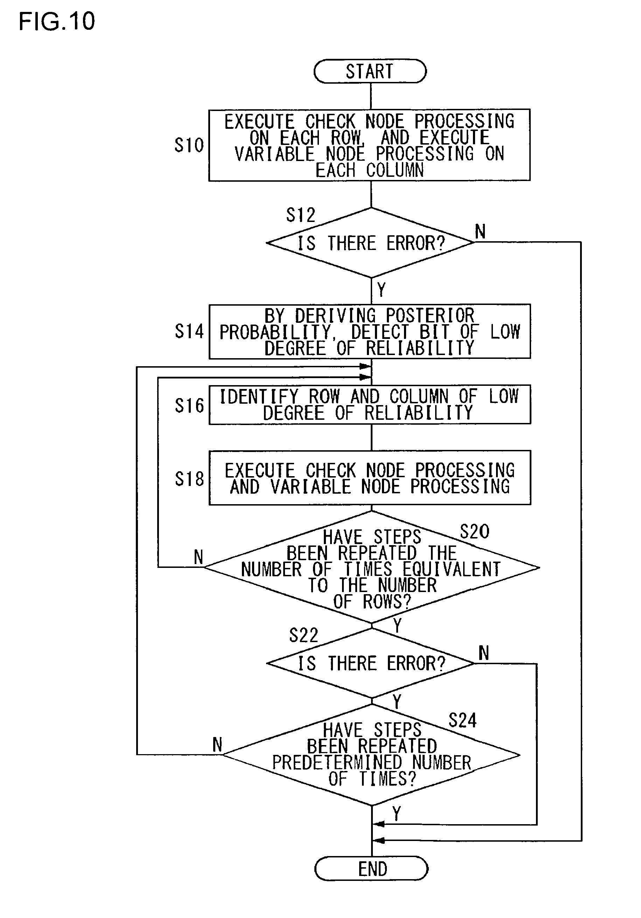

Operation of the communication system 100 having the above configuration will be described. FIG. 10 is a flowchart illustrating decoding procedure performed by the decoding unit 28. The min-sum processing unit 46 executes the check node processing on each row, and executes the variable node processing on each column (S10). This kind of processing is repeated a specific number of times. When there is no error (N in S12), the processing is terminated. On the other hand, when there is an error (Y in S12), the detection unit 50 detects the magnitude of the posterior probability, thus detecting a bit of a low degree of reliability (S14). The identifying unit 52 identifies a row and a column of a low degree of reliability (S16).

The min-sum processing unit 46 executes the check node processing on the row identified as well as executes the variable node processing on the column identified (S18). When steps S16 and S18 have not yet been repeated a number of times equivalent to the number of rows identified, (N in S20), step S16 is subsequently performed. When steps S16 and S18 have been repeated a number of times equivalent to the number of rows identified (Y in S20), and there is an error (Y in S22), but the steps have not yet been repeated a specific number of times (N in S24), step S16 is subsequently performed. In this case, the specific number of times is set separately from the specific number of times in step S10. When there is no error (N in S22), or the steps have been repeated the specific number of times (Y in S24), the processing is terminated.

According to the embodiment of the present invention, the row and the column subjected to the decoding processing can be limited by executing the check node processing on the row identified as well as executing the variable node processing on the column identified. Since the row and the column subjected to the decoding processing are limited, the number of times of operations of the check node processing and the variable node processing can be reduced. Since the number of times of operations of the check node processing and the variable node processing can be reduced, the speed of the iterative decoding can be enhanced. Since a bit of a low degree of reliability is derived based on the magnitude of the posterior probability, the accuracy in detecting the bit of the degree of reliability can be improved. Further, since the bit of the low degree of reliability is derived based on the magnitude of the posterior probability, and the posterior probability is derived due to another purpose, the increase of additional processing can be suppressed. Since a row of a low degree of reliability is identified from a bit of a low degree of reliability on the basis of a table, the processing can be simplified.

The present invention has been hereinabove described on the basis of the embodiments. The above embodiments are illustrative and will be understood by those skilled in the art that various modifications of a combination of the above constituent components or processes can be made and the modifications are also included in the scope of the present invention. Such modifications are included in the scope of the present invention.

In the embodiment of the present invention, since the communication system 100 is assumed to be the radio communication system, the transmission apparatus 10 and the reception apparatus 12 are included in a radio communication apparatus. However, the embodiment of the present invention is not limited thereto. For example, the communication system 100 may be a wired communication system. At this occasion, the transmission apparatus 10 and the reception apparatus 12 are included in a wired communication apparatus. According to the present modification, the present invention can be applied to various kinds of apparatuses.

In the embodiment of the present invention, when the decoded result obtained from repeated execution involves an error, the detection unit 50, the identifying unit 52, and the min-sum processing unit 46 repeatedly executes the processing. However, the embodiment of the present invention is not limited thereto. For example, when the processing is repeatedly executed, the comparison unit 62 may change the threshold value according to the number of repeated executions. More specifically, the comparison unit 62 reduces the threshold value according to the increase of the number of times of repeated executions. According to the present modification, the threshold value is reduced according to the number of times of repeated executions, and therefore, the number of bits of a low degree of reliability can be reduced.

In the embodiment of the present invention, the check node processing unit 56 sets the normalization constant to the same value no matter whether the check node processing is executed on each row of the check matrix or the check node processing is executed on the row identified by the identifying unit 52. However, the embodiment of the present invention is not limited thereto. For example, the check node processing unit 56 may make the latter smaller than the former. According to the present modification, the normalization constant after the error detection is reduced, and accordingly the amount of update can be reduced, and stable processing can be achieved.

In the embodiment of the present invention, the comparison unit 62 detects one bit of a low degree of reliability. However, the embodiment of the present invention is not limited thereto. For example, the comparison unit 62 may detect a plurality of bits of a low degree of reliability. In this case, the min-sum processing unit 46 may execute the repeat processing in order from a row and a column for a bit of a low degree of reliability. According to the present modification, the decoding property can be improved.

In the embodiment of the present invention, the decoding unit 28 executes the min-sum algorithm. However, the embodiment of the present invention is not limited thereto. For example, the decoding unit 28 may execute the sum-product algorithm instead of the min-sum algorithm. According to the present modification, the decoding property can be improved.

In the embodiment of the present invention, the transmission apparatus 10 executes the LDPC encoding. However, the embodiment of the present invention is not limited. The transmission apparatus 10 may execute encoding other than the LDPC encoding as long as the sum-product algorithm and the min-sum algorithm can be executed at decoding. According to the present modification, the present invention can be applied to various kinds of encoding.

## Claims

1. A decoding device (28) comprising:

    an input unit (40) operative to input data subjected to LDPC encoding;
    a decoding unit (46) operative to execute, on the data input by the input unit (40), check node processing for each row of a check matrix and variable node processing for each column of the check matrix;
    a detection unit (50) operative to detect a bit of a low degree of reliability from a decoded result of the decoding unit (46) when the decoded result of the decoding unit (46) involves an error; and

an identifying unit (52) operative to identify a row and a column of a low degree of reliability from the check matrix on the basis of the bit of the low degree of reliability detected by the detection unit (50), wherein

the decoding unit (46) executes, on the decoded result, check node processing of a row identified by the identifying unit (52) and variable node processing of a column identified by the identifying unit (52).

2. The decoding device (28) according to claim 1, wherein the detection unit (50) includes:

a deriving unit (60) operative to derive a magnitude of a posterior probability for each of a plurality of bits included in the decoded result of the decoding unit (46); and
a comparison unit (62) operative to compare the magnitude of the posterior probability derived by the deriving unit (60) with a threshold value, thereby detecting a bit of which magnitude of the posterior probability is less than the threshold value, as a bit of a low degree of reliability.

3. The decoding device (28) according to claim 2, wherein when the decoded result obtained from repeated execution involves an error, the detection unit (50), the identifying unit (52), and the decoding unit (46) repeatedly execute the processing, and
the comparison unit (62) changes a threshold value according to the number of times of repeated executions.

4. The decoding device (28) according to any one of claim 1 to claim 3, wherein
the decoding unit (46) executes min-sum algorithm for the check node processing, and
a normalization constant for execution of the check node processing of each row of the checkmatrix is less than a normalization constant for execution of the check node processing of the row identified by the identifying unit (52).

5. A decoding method comprising the steps of:

inputting data subjected to LDPC encoding;
executing, on the input data, check node processing for each row of a check matrix;
executing, on the input data, variable node processing for each column of the check matrix;
detecting a bit of a low degree of reliability from a decoded result when the decoded result involves an error;
identifying a row and a column of a low degree of reliability from the check matrix on the basis of the bit of the low degree of reliability detected;
executing, on the decoded result, check node processing of a row identified; and
executing, on the decoded result, variable node processing of a column identified.

# FIG.1

FIG.2

$$Hmn = \begin{bmatrix} 1 & 1 & 1 & 1 & 0 & 0 & 0 & 0 \\ 1 & 0 & 1 & 0 & 1 & 0 & 1 & 0 \\ 0 & 1 & 0 & 1 & 0 & 1 & 0 & 1 \\ 0 & 0 & 0 & 0 & 1 & 1 & 1 & 1 \end{bmatrix}$$

FIG.3

FRAME CONFIGURA-TION UNIT 40

CONTROL UNIT 42

DETECTION UNIT 50 62

DERIVING UNIT 60

COMPAR-ISON UNIT 62

IDENTI-FYING UNIT 52

TABLE STORAGE UNIT 54

min-sum PROCESSING UNIT 46

CHECK NODE PROCESSING UNIT 56

VARIABLE NODE PROCESSING UNIT 58

DATA STORAGE UNIT 44

DECODED RESULT CALCULATION UNIT 48

DECODING UNIT

28

EP 2 479 897 A2

FIG.4

FIG.5

b0  b1  b2  b3

$\alpha$ 00    $\beta$ 00'

c0

FIG.6

FIG.7

|  | | COLUMN NUMBER | | | | | | | | ROW WEIGHT |
|---|---|---|---|---|---|---|---|---|---|---|
|  | | 0 | 1 | 2 | 3 | 4 | 5 | 6 | 7 | |
| ROW NUMBER | 0 | 1 | 1 | 1 | 1 | 0 | 0 | 0 | 0 | 4 |
| | 1 | 1 | 0 | 1 | 0 | 1 | 0 | 1 | 0 | 4 |
| | 2 | 0 | 1 | 0 | 1 | 0 | 1 | 0 | 1 | 4 |
| | 3 | 0 | 0 | 0 | 0 | 1 | 1 | 1 | 1 | 4 |
| COLUMN WEIGHT | | 2 | 2 | 2 | 2 | 2 | 2 | 2 | 2 | |

FIG.8

| | | ROW INDEX | |
|---|---|---|---|
| | | 0 | 1 |
| C O L U M N   N U M B E R | 0 | 0 | 1 |
| | 1 | 0 | 2 |
| | 2 | 0 | 1 |
| | 3 | 0 | 2 |
| | 4 | 1 | 3 |
| | 5 | 2 | 3 |
| | 6 | 1 | 3 |
| | 7 | 2 | 3 |

FIG.9

|  | b0 | b1 | b2 | b3 | b4 | b5 | b6 | b7 |
|---|---|---|---|---|---|---|---|---|
|  | 1 | 1 | 1 | 1 | 0 | 0 | 0 | 0 |
|  | 1 | 0 | 1 | 0 | 1 | 0 | 1 | 0 |
|  | 0 | 1 | 0 | 1 | 0 | 1 | 0 | 1 |
|  | 0 | 0 | 0 | 0 | 1 | 1 | 1 | 1 |

## FIG.10

```
           ┌──────────┐
           │  START   │
           └──────────┘
                │
    ┌───────────────────────────────┐
    │ EXECUTE CHECK NODE PROCESSING  │
S10 │  ON EACH ROW, AND EXECUTE      │
    │ VARIABLE NODE PROCESSING ON    │
    │        EACH COLUMN             │
    └───────────────────────────────┘
                │
S12        ◇─────────────◇            N
        ⟨ IS THERE ERROR? ⟩──────────────┐
           ◇─────────────◇               │
                │ Y                       │
    ┌───────────────────────────────┐    │
    │ BY DERIVING POSTERIOR          │    │
S14 │ PROBABILITY, DETECT BIT OF LOW │    │
    │   DEGREE OF RELIABILITY        │    │
    └───────────────────────────────┘    │
                │                         │
    ┌───────────────────────────────┐    │
S16 │ IDENTIFY ROW AND COLUMN OF LOW │    │
    │   DEGREE OF RELIABILITY        │    │
    └───────────────────────────────┘    │
                │                         │
    ┌───────────────────────────────┐    │
S18 │ EXECUTE CHECK NODE PROCESSING  │    │
    │ AND VARIABLE NODE PROCESSING   │    │
    └───────────────────────────────┘    │
                │                         │
          ◇──────────────◇  S20          │
        ⟨ HAVE STEPS       ⟩             │
     N  ⟨ BEEN REPEATED THE ⟩            │
   ┌────⟨ NUMBER OF TIMES EQUIVALENT ⟩   │
   │    ⟨ TO THE NUMBER    ⟩             │
   │    ⟨ OF ROWS?         ⟩             │
   │        ◇──────────────◇             │
   │            │ Y                      │
   │ S22   ◇──────────────◇      N       │
   │    ⟨ IS THERE ERROR? ⟩──────────────┤
   │       ◇──────────────◇              │
   │            │ Y                      │
   │        ◇──────────────◇  S24        │
   │ N    ⟨ HAVE STEPS      ⟩            │
   └──────⟨ BEEN REPEATED   ⟩            │
          ⟨ PREDETERMINED NUMBER ⟩       │
          ⟨ OF TIMES?      ⟩             │
             ◇──────────────◇            │
                 │ Y                     │
                 ├─────────────◄─────────┘
           ┌──────────┐
           │   END    │
           └──────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008219528 A